# FASCICULE DE BREVET EUROPEEN

(11) **EP 2 912 690 B1**
(45) Date de publication et mention de la délivrance du brevet: **25.12.2019**
(21) Numéro de dépôt: 13783550.0
(22) Date de dépôt: 25.10.2013
(51) Int. Cl.: H01L 27/146, H04N 5/355, H04N 5/359, H04N 5/369

(54) **STRUCTURE D'UN PIXEL ACTIF DE TYPE CMOS**
STRUKTUR EINES AKTIVEN CMOS-PIXEL
STRUCTURE OF A CMOS ACTIVE PIXEL

(30) Priorité: 26.10.2012 FR 1260260
(43) Date de publication de la demande: 02.09.2015
(73) Titulaire: New Imaging Technologies, 91370 Verrières-le-Buisson (FR)
(72) Inventeur: NI, Yang, F-91120 Palaiseau (FR)
(74) Mandataire: Regimbeau
(86) Numéro de dépôt international: PCT/EP2013/072444
(87) Numéro de publication internationale: WO 2014/064274

(56) Documents cités:
- WO-A1-2009/103048
- JP-A- 2009 182 223
- US-A1- 2006 043 519
- US-A1- 2010 327 390
- US-A1- 2012 085 888

## Description

### DOMAINE TECHNIQUE GENERAL

La présente invention concerne le domaine des pixels actifs de type CMOS (acronyme de l'anglais Complementary Metal Oxide Semiconductor pour semi-conducteur à oxyde de métal complémentaire), qui met en oeuvre une famille de composants électroniques à faible consommation électrique. L'invention concerne en particulier des structures de pixels CMOS et les capteurs matriciels d'images les incorporant.

La technologie d'intégration CMOS permet de réaliser des puces pour caméras monolithiques de bonne résolution et de qualité d'image raisonnable. La mise en oeuvre de ces techniques permet par ailleurs d'obtenir des capteurs présentant une faible consommation énergétique. De tels capteurs offrent également une vitesse de lecture rapide grâce à la rapidité de commutation des transistors CMOS. En outre, ces technologies offrent la possibilité d'intégrer les fonctions de conditionnement, de traitement, de codage et de communication.

### CONTEXTE DE L'INVENTION

Dans un pixel conventionnel, les paires électrons-trous générées dans une photodiode sont intégrés dans un condensateur donnant un signal soit en tension soit en charge électrique.

La valeur de ce condensateur détermine la quantité maximale de charge qu'il peut recevoir sans saturation car la tension sur la capacité est toujours limitée dans un pixel. Une plus grande valeur donne une plus grande capacité d'intégration, donc une plus grande dynamique de fonctionnement. Mais une grande valeur du condensateur d'intégration donne une plus faible tension pour la même quantité de charge intégrée, donc une moins bonne sensibilité. Dans beaucoup de cas, cette capacité d'intégration est simplement la capacité de la jonction de la photodiode.

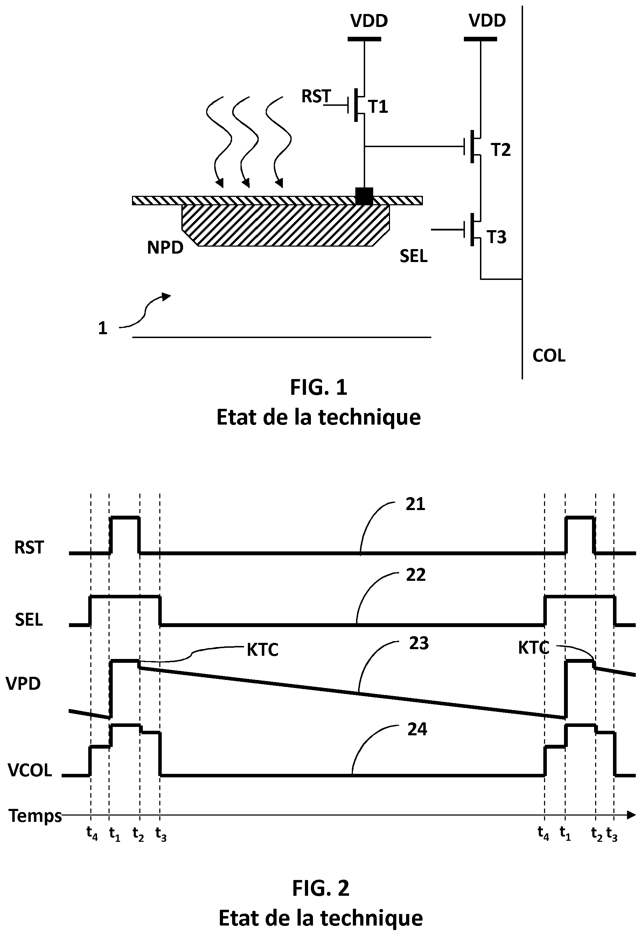

Un exemple typique de cette configuration est une structure de pixel actif (ou APS pour Active Pixel Sensor selon la terminologie anglo-saxonne) CMOS à trois transistors illustré dans la figure 1. Un tel pixel comprend
- un substrat 1 semi-conducteur de type P ;
- une zone de conversion photoélectrique définie par une zone dopée NPD de type N formant une jonction PN avec le substrat et accumulant une quantité de charges pendant une exposition à la lumière, la jonction PN constituée par la zone de conversion photoélectrique et le substrat constituant la cathode et l'anode d'une photodiode ;
- une couche d'isolation en dioxyde de silicium à la surface du substrat 1 ;
- un circuit de lecture pour lire une variation de tension induite par l'accumulation de charge, ledit circuit de lecture comprenant :
   - un transistor d'initialisation T1 commandé par un signal d'initialisation RST sur sa grille pour initialiser la tension de la photodiode en pré-charge, ledit transistor d'initialisation T1 ayant une électrode reliée à la zone de conversion photoélectrique NPD et une autre électrode reliée à la tension d'alimentation VDD ;
   - un transistor de lecture T2 dont la grille est reliée à la zone de conversion photoélectrique NPD, tandis qu'une de ses électrode est reliée à la tension d'alimentation VDD,
   - un transistor de sélection T3 commandé par un signal de sélection SEL applicable à sa grille, une de ses électrodes étant commune avec l'autre électrode du transistor de lecture T2, et l'autre étant reliée un bus de lecture COL.

Ainsi, la charge photoélectrique s'auto-intègre sur la capacité de jonction de la photodiode après l'action de pré-charge du transistor d'initialisation T1, puis est lue au moyen de la commutation du transistor de sélection T3. La séquence de lecture est illustrée par la figure 2, qui présente un chronogramme de fonctionnement typique du pixel actif CMOS à trois transistors présenté sur la figure 1.

Sur ce chronogramme sont schématiquement représentées, en valeur arbitraire en fonction du temps, l'évolution 21 du signal d'initialisation RST, l'évolution 22 du signal de sélection SEL, l'évolution 23 de la tension VPD au niveau de la zone de conversion photoélectrique, c'est-à-dire de la photodiode, et l'évolution 24 de la tension VCOL sur la ligne de lecture COL.

Au temps t₁, la photodiode est initialisée ou préchargée, avant une prise de vue, à une tension initiale, à l'aide d'un signal RST activant le transistor d'initialisation T1. Au temps t₂, le transistor d'initialisation T1 est désactivé et une lecture initiale permet de déterminer ladite tension initiale pour supprimer ensuite un décalage d'un suiveur de tension du circuit de lecture. Au temps t₃, le transistor de sélection T3 est désactivé au moyen du signal de sélection SEL, afin de laisser la photodiode évoluer sous une illumination pendant l'exposition. Ensuite l'accumulation de la charge photoélectrique fait chuter la tension sur la photodiode (VPD). Cette variation de tension sera lue par le transistor T2 en mode suiveur de tension. Enfin, au temps t₄, on effectue la lecture finale à la fin de l'exposition à l'aide du signal de sélection SEL, afin de récupérer la tension représentative de l'illumination. Le signal de sortie final sera la différence entre la lecture finale et la lecture initiale.

On peut constater que rajout d'une capacité supplémentaire à celle de la photodiode permet d'augmenter la limite du niveau de saturation, mais il dégrade considérablement la sensibilité du pixel. Par conséquent, la plage de fonctionnement n'est pas beaucoup améliorée. Il est plus intéressant de réduire la capacité d'intégration afin d'avoir une bonne sensibilité. La limite du niveau de saturation peut être contrôlée par le temps de pose, l'ouverture de l'optique, etc.

La réduction de la capacité d'intégration est limitée par la structure intrinsèque de la photodiode. C'est la photodiode, par l'intermédiaire de sa zone de conversion photoélectrique, qui collecte les photons, donc on ne peut pas réduire sa surface sans perdre l'efficacité de la collecte des photons, et donc sans perdre en sensibilité. Les brevets US 6 531 725, US 6 051 447 et US 5 903 021 proposent des solutions visant à réduire la capacité de jonction de la photodiode dans un tel pixel. Ces solutions utilisent des jonctions PN de la photodiode dont la zone de conversion photoélectrique de type N est partiellement déplétée avec la polarisation inverse.

Cependant, une faible capacité de la jonction de la photodiode implique un problème de bruit lié à l'initialisation de la photodiode, un bruit de commutation KTC. Ce bruit de commutation KTC perturbe la bonne lecture de la tension initiale, et ne peut être facilement compensé, sauf à disposer par exemple de systèmes complexes à mémoire.

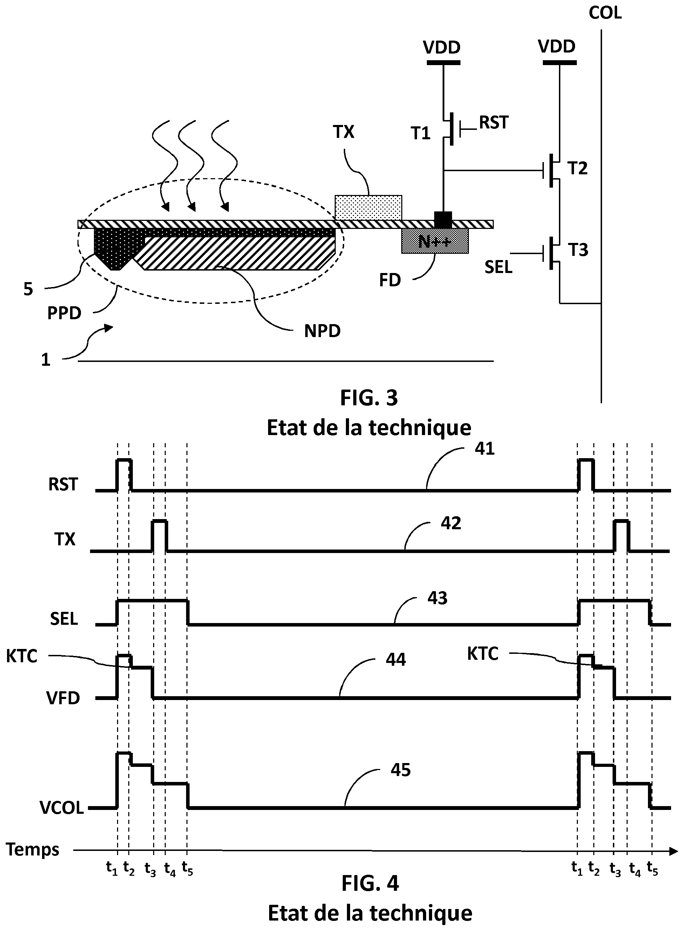

Afin d'améliorer la sensibilité et de réduire les bruits, des structure de pixel actif CMOS à transfert de charge ont été proposés. Comme illustré dans la FIG. 3, un transistor de transfert TX est ajouté dans un pixel actif à trois transistors entre la photodiode et le transistor de lecture T2. Ce transistor de transfert, dit « transfer gate », permet un transfert de la charge photoélectrique accumulée dans la zone NPD vers un nœud de diffusion flottant FD, constitué d'une jonction PN de très petite taille. Ce nœud de diffusion flottant FD possède en générale une faible valeur de capacité, donc le gain de conversion charge-tension est fortement augmenté. Grâce à ce transfert de charge, le gain de conversion n'est plus lié à la capacité de jonction de la photodiode NPD. Une telle structure, dite à quatre transistors, permet d'augmenter la sensibilité du pixel, et permet par exemple d'envisager des applications exigeant une forte sensibilité, telle que la vision nocturne.

Un pixel à quatre transistors à transfert de charge tel qu'illustré sur la figure 3 présente un autre avantage qui améliore encore la sensibilité du pixel. Le transistor d'initialisation T1 de la photodiode injecte un bruit de commutation KTC, en charge, dans la photodiode au moment il est coupé. Ce bruit dit KTC est proportionnel à la racine carrée du produit KTC, avec K la constante de Boltzmann, T la température absolue, et C a valeur de la capacité. Dans un pixel à trois transistors tel que celui de la figure 1, il est assez difficile de compenser ce bruit KTC de reset car le bruit est produit au début de l'exposition et le signal d'image est lu à la fin de l'exposition. Ceci explique que la faible sensibilité d'un capteur d'image à base des pixels à trois transistors.

Dans un pixel à quatre transistors, la situation est très différente. La lecture du signal d'image est précédée par une initialisation, ou reset, du nœud de diffusion flottant FD juste avant le transfert de charge. Une opération différentielle permet de supprimer ce bruit KTC.

La figure 4 montre le chronogramme du pixel actif à quatre transistors. Sur ce chronogramme est schématiquement représentées, en valeur arbitraire en fonction du temps, l'évolution 41 du signal d'initialisation RST, l'évolution 42 du signal appliqué à la grille du transistor de transfert TX, l'évolution 43 du signal de sélection SEL, l'évolution 44 de la tension VFD au niveau du nœud de diffusion flottant FD et l'évolution 45 de la tension VCOL sur la ligne de lecture COL.

Au temps t₁, le nœud de diffusion flottant FD est initialisé, avant une prise de vue, à une tension initiale, à l'aide du signal RST activant le transistor d'initialisation T1, et le transistor de sélection T3 est rendu passant au moyen du signal de sélection SEL.

Au temps t₂, le transistor d'initialisation T1 est désactivé au moyen du signal RST et une lecture initiale permet de déterminer ladite tension initiale. Au temps t₃, le transistor de transfert TX est rendu passant afin de transférer les charges depuis la zone de conversion photoélectrique NPD vers le nœud de diffusion flottant FD. Au temps t₄, le transistor de transfert TX est désactivé, tandis qu'une seconde lecture a lieu sur la ligne de lecture. Au temps t₅, le transistor de sélection T3 est désactivé.

Le signal de sortie est la différence entre la lecture initiale et la seconde lecture, et est constitué de la variation de tension provoquée par la charge photoélectrique accumulée dans la zone de conversion photoélectrique NPD qui a été transférée au nœud de diffusion flottant FD. Le bruit d'initialisation du nœud flottant FD est donc compensé naturellement par le circuit de lecture différentielle.

Ainsi, l'influence du bruit KTC induit par la capacité du nœud de diffusion flottant FD peut effectivement être supprimé par une lecture différentielle, mais celui induit par la capacité de la jonction de la photodiode ne l'est pas.

L'invention de la « pinned photodiode » (PPD) a permis de surmonter cette difficulté. Illustrée dans la FIG. 3, une pinned photodiode est constituée d'une zone de conversion photoélectrique, typiquement une diffusion de type N, formant avec le substrat 1 une jonction PN et constituant la photodiode, en sandwich entre le substrat 1, typiquement de type P, et une zone dopée 5, également appelée zone de passivation, résultant d'une diffusion surfacique généralement d'une très faible profondeur et d'une forte dose du même type que le substrat, typiquement P, qui isole la zone de conversion photoélectrique NPD de la surface du substrat 1. Quand la photodiode est polarisée avec une tension suffisamment élevée, la zone de conversion photoélectrique NPD est complètement déplétée de charge mobile. Les charges spatiales de la zone de conversion photoélectrique NPD attirent et accumulent les photoélectrons générés par les photons pendant la période d'exposition.

A la fin d'exposition, le transistor de transfert TX transfère ces photoélectrons accumulés dans la zone de conversion photoélectrique NPD vers le nœud de diffusion flottant FD pour les y convertir en tension. Si ce transfert est total, la photodiode PPD se retrouve de nouveau exempte de charge mobile. Il n'y a donc pas de génération du bruit de commutation KTC dans ce cas.

Un transfert total des photoélectrons est primordial non seulement pour la suppression du bruit de commutation KTC mais aussi pour éviter un éventuel effet de trainée dans l'image. La demande de brevet déposée en France sous le numéro FR 1251387 (le numéro de publication correspondant FR2986906) présente par exemple une structure permettant un bon fonctionnement du transistor de transfert TX avec un procédé CMOS simple.

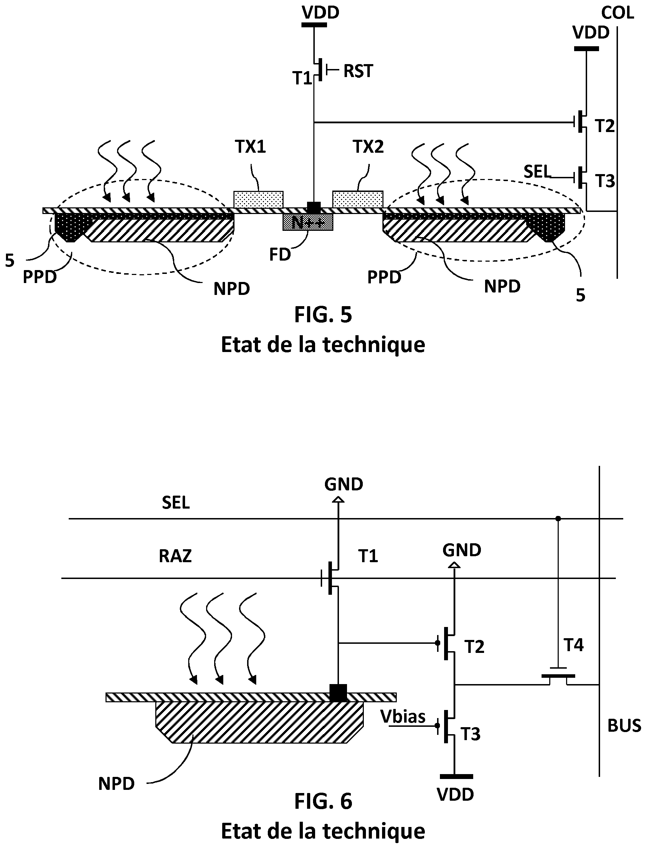

Un avantage d'un pixel à quatre transistors est que la partie lecture peut être facilement partagée par plusieurs photodiodes PPD. La figure 5 montre le principe de ce partage. Deux photodiodes PPD sont disposées de part et d'autre d'un nœud de diffusion flottant FD, auquel chacune des photodiodes PPD peut être reliée au moyen d'un transistor de transfert TX1, TX2. Les brevets US7964929 et US7989749 donnent plus de détails à ce sujet. Grâce à cette possibilité de partage de l'amplification de lecture, des pixels de très petite taille peuvent aujourd'hui être réalisés aujourd'hui, souvent utilisés dans les caméras de téléphones mobiles.

Des structures de pixel visant à améliorer l'efficacité et optimiser le transfert de charges sont aussi connues des documents US 2012/085888 A1, US 2010/327390 A1, US 2006/043519 A1, JP 2009 182223 A et WO 2009/103048 A1.

Ces différentes configurations de structure de pixel à transfert de charge ont contribué à améliorer la limite de sensibilité des pixels, tout en réduisant leur taille. Mais la dynamique de fonctionnement n'a pas du tout été améliorée, et a parfois même régressé. Car la faible valeur capacité du nœud de diffusion flottant FD limite la capacité d'accumulation. Par exemple, le capteur CMOS OV7955 à base de pixels à quatre transistors, de dimension 6 µm x 6 µm, de OmniVision Technology, donne une excellente de sensibilité (12V/lux*s) mais sature à seulement 6000 photo-électrons.

Afin d'étendre la dynamique de fonctionnement et de retarder la saturation, des approches à base de multiples poses sont exploitées dans un certain nombre de produits commerciaux. Elle consiste à capter une scène avec plusieurs paramètres de prise de vue et à ensuite combiner ces prises de vue afin d'obtenir une image de plus grande dynamique. Ces approches nécessitent des traitements d'image complexes. Il est en outre souvent difficile de trouver en temps réel les paramètres de prise de vue optimaux dans un environnement changeant et/ou complexe.

Les documents EP 1 354 360 A1, WO 2009/027449 A1 et WO 2010/103464 A1 proposent une conception de pixel où la photodiode fonctionne en mode photovoltaïque, comme une cellule solaire, contrairement à des conceptions conventionnelles où la photodiode fonctionne comme une source de courant contrôlée par la lumière. La figure 6 montre la structure d'un pixel à base de photodiode en mode photovoltaïque présentée dans le brevet EP 1 354 360. Elle montre une similitude à un pixel classique à trois transistors, mais présente deux différences fondamentales : la zone de conversion photovoltaïque est court-circuitée pendant l'action d'initialisation, et la jonction de la photodiode est auto-polarisée en directe par les pairs électrons-trous générés par les photons incidents. Le signal d'image est obtenu par une lecture différentielle entre la tension photovoltaïque et la tension zéro pendant la réinitialisation, ou reset.

Dans ce mode de fonctionnement, la tension sur les bornes d'une photodiode en circuit ouvert est mesurée comme signal. Cette tension selon la loi de Schokley est liée à l'intensité lumineuse par une relation logarithmique. Cette relation logarithmique compresse l'évolution du signal et donne une plus large dynamique de fonctionnement. Malgré ses nombreux avantages, ce mode de fonctionnement photovoltaïque présente un certain nombre d'inconvénients, notamment en termes de sensibilité, auxquels la présente invention vise à pallier.

### PRESENTATION DE L'INVENTION

Un but de l'invention est de proposer une structure de pixel combinant une grande dynamique de fonctionnement et une bonne sensibilité, tout en restant de conception simple et peu encombrante.

Plus précisément, l'invention propose une structure d'un pixel actif de type CMOS, selon la revendication 1, comprenant
- un substrat semi-conducteur d'un premier type,
- au moins une première photodiode configurée pour opérer en mode photovoltaïque lors de l'exposition de ladite première photodiode à un rayonnement comprenant une zone de conversion photovoltaïque définie par une zone dopée d'un second type formant une jonction PN avec le substrat, ladite première photodiode étant configurée pour réémettre des porteurs de charge photoélectriques captées par la jonction PN lors de l'exposition de ladite première photodiode à un rayonnement,
- au moins une seconde photodiode configurée pour opérer en mode intégration et être polarisée en inverse lors de l'exposition de ladite première photodiode à un rayonnement, ladite seconde photodiode comprenant une zone d'accumulation de charge définie par une zone dopée du second type formant une jonction PN avec le substrat, ladite zone d'accumulation de charge étant configurée pour être exposée aux porteurs de charge issus de la zone de conversion photovoltaïque pour accumuler de tels porteurs de charge, et
- des moyens de lecture pour lire la tension de la première photodiode et lire une mesure des charges de la seconde photodiode.

Dans cette description, les termes premier type et second type se rapportent au type de semi-conducteur, c'est-à-dire au type P et au type N. Le premier et le second type sont différents. Typiquement, le premier type correspond au type P, tandis que le second type correspond au type N. Alternativement, il est possible d'avoir le premier type correspondant au type N, tandis que le second type correspond alors au type P.

L'exposition de la seconde photodiode aux porteurs de charge issus de la zone de conversion photovoltaïque de la première photodiode permet à celle-ci d'accumuler lesdits porteurs de charge, qui autrement diffuseraient dans le substrat. La récupération des porteurs de charge permet d'améliorer significativement la sensibilité du pixel sans compromettre la grande dynamique de fonctionnement permise par la première photodiode en mode photovoltaïque.

L'invention est avantageusement complétée par les caractéristiques suivantes, prises seules ou en une quelconque de leur combinaison techniquement possible :
- la zone de conversion photovoltaïque et la zone d'accumulation de charge sont séparées par une portion de substrat que les porteurs de charge réémis par la première photodiode traversent pour être collectés et accumulés dans la zone d'accumulation, de sorte que la zone de déplétion de la jonction PN de la première photodiode et la zone de déplétion de la jonction PN de la seconde photodiode sont distinctes et ne se touchent pas ;
- le substrat présente une modulation spatiale de dopage définissant une zone de contention des porteurs de charge, ladite zone de contention regroupant la première et la seconde photodiode pour contenir les porteurs de charges afin de favoriser l'efficacité de la collecte de porteurs de charge issus de la zone de conversion photovoltaïque par la zone d'accumulation de charge ;
- la distance entre la zone de conversion photovoltaïque et la zone d'accumulation de charge est comprise entre 0,1 µm et 100 µm ;
- la ou les premières photodiodes et la ou les secondes photodiodes sont intercalées entre elles dans le substrat de sorte qu'une zone de conversion photovoltaïque est adjacente à au moins une zone d'accumulation de charge de la seconde photodiode ;
- la zone de conversion photovoltaïque et la zone d'accumulation de charge sont au moins partiellement superposées ;
- la zone d'accumulation de charge a une extension spatiale couvrant au moins l'étendue de ladite zone de conversion photovoltaïque ;
- la seconde photodiode comprend une couche de passivation présentant un dopage de même type que le substrat et séparant la zone d'accumulation de charge d'une surface du substrat ;
- un transistor de réinitialisation RSTLOG est adapté pour connecter une zone de réinitialisation ménagée dans le substrat à la zone de conversion photovoltaïque.
- la zone de réinitialisation est formée par un contact-substrat constitué d'une zone fortement dopée du premier type dans le substrat ;
- la zone de réinitialisation est constituée d'une zone fortement dopée du second type polarisée par une tension variable Vx, afin de propager ladite tension variable Vx jusqu'au nœud de diffusion flottant associé à la zone d'accumulation.

Selon l'invention, les moyens de lecture de la première photodiode et de la seconde photodiode comprennent un circuit de lecture commun à la première photodiode et à la seconde photodiode, au niveau du pixel, connecté à un bus COL commun pour lire la tension de la première photodiode et lire une mesure des charges de la seconde photodiode. La structure est alors à transfert de charge et, dans un mode de réalisation comprend un nœud de diffusion flottant associé à la zone d'accumulation de charge, et le circuit de lecture commun comprend :
- une structure à transfert de charge adaptée pour lire la tension d'un nœud de diffusion flottant associé à la seconde photodiode,
- un circuit de décalage de tension connectant la première photodiode au nœud de diffusion flottant par l'intermédiaire d'un transistor d'initialisation de la structure à transfert de charge associé à la seconde photodiode.

Le circuit de décalage de tension peut alors comporter un transistor à tension de seuil négative dont la grille est reliée à la zone de conversion photovoltaïque. Dans un autre mode de réalisation possible, la structure comprend un nœud de diffusion flottant associé à la zone d'accumulation de charge, le circuit de lecture commun comprend une structure à transfert de charge adaptée pour lire la tension d'un nœud de diffusion flottant associé à la seconde photodiode, et la zone de conversion photovoltaïque est connectée au nœud de diffusion flottant par un condensateur.

L'invention concerne également un capteur selon la revendication 15, comprenant
- une pluralité de structure de pixels selon l'invention, et
- au moins un circuit de sortie combinant la lecture de la tension de la première photodiode et la lecture d'une mesure des charges de la seconde photodiode.

L'invention concerne également un procédé de fonctionnement d'un pixel actif de type CMOS selon la revendication 16, présentant une structure selon l'invention, dans lequel
- la première photodiode opère en mode photovoltaïque et réémet des porteurs de charges photoélectriques captées par la jonction PN lors de l'exposition de ladite première photodiode à un rayonnement,
- la seconde photodiode est polarisée en inverse et opère en mode intégration, ladite zone d'accumulation de charge étant exposée aux porteurs de charge issus de la zone de conversion photovoltaïque pour accumuler de tels porteurs de charge,
- la tension de la première photodiode et une mesure des charges de la seconde photodiode sont lues par des moyens de lecture.

### BREVE DESCRIPTION DES FIGURES

Dans les parties suivantes de la description, les termes et les expressions "mode de réalisation" et "selon l'invention" sont utilisés. Indépendamment de la signification de ces termes et expressions, seuls les exemples couverts par les revendications font partie de l'invention.

D'autres caractéristiques et avantages de l'invention ressortiront encore de la description qui suit, laquelle est purement illustrative et non limitative. Cette description doit être lue sur la base des dessins annexés, sur lesquels :
- la figure 1, déjà commentée, est un schéma illustrant la structure d'un pixel actif à trois transistors de l'état de la technique ;
- la figure 2, déjà commentée, est un chronogramme illustrant les signaux intervenant lors du fonctionnement du pixel de la figure 1;
- la figure 3, déjà commentée, est un schéma illustrant la structure d'un pixel actif à quatre transistors de l'état de la technique ;
- la figure 4, déjà commentée, est un chronogramme illustrant les signaux intervenant lors du fonctionnement du pixel de la figure 3 ;
- la figure 5, déjà commentée, est un schéma illustrant le partage d'un circuit de lecture par deux pixels similaires à celui de la figure 3 ;
- la figure 6, déjà commentée, est un schéma illustrant la structure d'un pixel actif à quatre transistors de l'état de la technique, fonctionnant en mode photovoltaïque ;
- la figure 7 est un schéma en coupe illustrant un mode de réalisation possible d'une structure de pixel selon l'invention ;
- la figure 8 est un graphique représentant schématiquement les réponses de photodiodes respectivement en mode photovoltaïque et en mode intégration, en fonction de l'intensité lumineuse à laquelle elles sont soumises ;
- la figure 9 est un schéma en coupe illustrant un mode de réalisation possible d'une structure de pixel selon l'invention, dans lequel l'exposition est faite par la face arrière du substrat ;
- la figure 10 est un graphique présentant des profondeurs d'implantation de différentes espèces dopantes en fonction de l'énergie d'implantation ;
- les figures 11 et 12 présentent sur leur partie droite une vue de dessus d'une matrice de pixels et sur leur partie gauche une vue agrandie d'un pixel selon un mode de réalisation possible de l'invention ;
- la figure 13 présente le principe de l'action anti-blooming mise en oeuvre pour un pixel à trois transistors ;
- les figures 14 et 15 présentent respectivement le schéma électrique et une vue en coupe d'un agencement des zones d'une structure de pixel selon un mode de réalisation possible de l'invention, dans lequel les deux photodiodes sont lues par un circuit commun ;
- la figure 16 est un chronogramme illustrant le fonctionnement de la structure des figures 14 et 15 ;
- les figures 17 et 18 présentent respectivement le schéma électrique et une vue en coupe d'un agencement des zones d'une structure de pixel selon un mode de réalisation possible de l'invention, avec une variante dans laquelle une tension est appliquée à la zone de conversion photovoltaïque au lieu de la court-circuiter pour son initialisation ;
- la figure 19 est un chronogramme illustrant le fonctionnement de la structure des figures 17 et 18 ;
- la figure 20 est un schéma électrique d'une structure de pixel selon un mode de réalisation possible de l'invention, dans laquelle le circuit de lecture commun comporte un condensateur ;
- la figure 21 est un chronogramme illustrant le fonctionnement de la structure de la figure 20 ;
- les figures 22 et 23 sont des vues en coupe de modes de réalisation possible de l'invention dans lesquels la fonction anti-blooming est mise en oeuvre dans une structure à quatre transistors.

### DESCRIPTION DETAILLEE

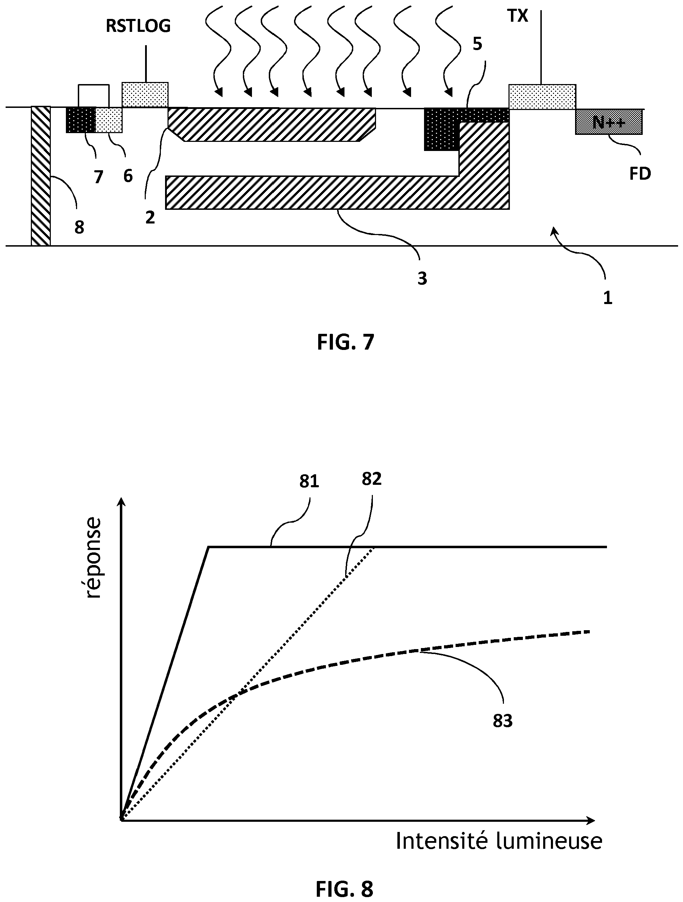

En référence à la figure 7, une structure d'un pixel actif de type CMOS selon un mode de réalisation possible de l'invention, comprenant
- un substrat 1 semi-conducteur d'un premier type,
- au moins une première photodiode opérant en mode photovoltaïque comprenant une zone de conversion photovoltaïque 2 définie par une zone dopée d'un second type formant une jonction PN avec le substrat, ladite première photodiode réémettant des porteurs de charge photoélectriques captées par la jonction PN lors de l'exposition de ladite première photodiode à un rayonnement,
- au moins une seconde photodiode opérant en mode intégration et polarisée en inverse, ladite seconde photodiode comprenant une zone d'accumulation de charge 3 définie par une zone dopée du second type formant une jonction PN avec le substrat, ladite zone d'accumulation de charge étant exposée aux porteurs de charge issus de la zone de conversion photovoltaïque 2 pour collecter et accumuler de tels porteurs de charge.

La structure du pixel de la présente invention réunit une photodiode en mode photovoltaïque, une photodiode en mode intégration et un couplage de charge entre la photodiode en mode photovoltaïque et la photodiode en mode intégration.

Sur la figure 8 sont représentées les réponses de photodiodes respectivement en mode photovoltaïque et en mode intégration, en fonction de l'intensité lumineuse à laquelle elles sont soumises. La courbe en trait continu 81 illustre la réponse d'une photodiode en mode intégration, au cours d'une longue exposition, tandis que la courbe en pointillés 82 illustre la réponse de cette photodiode lors d'une courte exposition. On constate qu'une photodiode en mode intégration présente rapidement une saturation qui empêche de rendre compte des intensités lumineuses trop fortes.

La courbe en tirets 83 illustre la réponse en tension de la photodiode en mode photovoltaïque, c'est-à-dire auto-polarisée en direct. On constate que la réponse en tension prend une forme logarithmique qui permet de rendre compte des intensités lumineuses mêmes fortes.

Ainsi, une photodiode en mode d'intégration et une photodiode en mode photovoltaïque sont très complémentaires : la photodiode en mode photovoltaïque offre une très grande dynamique de fonctionnement mais une plus faible sensibilité à la lumière, tandis que la photodiode en mode intégration possède une excellente sensibilité, notamment pour un pixel à quatre transistors à base de "pinned photodiode", mais une très faible dynamique de fonctionnement. Une combinaison de ces photodiodes permet donc de créer un pixel très performant à la fois au regard de la sensibilité et en dynamique de fonctionnement.

Une photodiode pré-chargée à une tension de polarisation inverse non nulle avant l'exposition peut générer une réponse qui passerait d'un mode intégration vers un mode photovoltaïque. De fait, le fonctionnement d'une photodiode en mode photovoltaïque peut exister et peut être observable dans un capteur CMOS classique quand l'amplificateur dans le pixel permet de lire la tension négative sur la cathode de la photodiode.

Cependant, cette configuration est généralement proscrite dans les configurations matricielles de l'état de la technique, puisque les photodiodes en mode intégration vont collecter les charges libérées par les photodiodes voisines qui sont en mode photovoltaïques, et, dans ce cas, les charges libérées par les photodiodes en mode photovoltaïques entachent les photodiodes encore polarisées en inverse (i.e. en mode intégration) et rendent l'image inexploitable. On obtient alors une diaphonie inacceptable entre les photodiodes. Ceci explique l'absence d'investigation sur les pixels à photodiode en mode photovoltaïque avant les travaux de recherche publiés dans « Y. Ni, K. Matou, "A CMOS Log Image Sensor with on-chip FPN Compensation", ESSCIRC'01, 18-20 Sept. 2001 Villach, Austria, pp. 128-132» et décrits dans le brevet EP1354360.

Dans l'invention, cet effet n'est pas évité mais recherché, et la structure de pixel est adaptée pour générer cet effet de collecte par une photodiode en mode intégration des porteurs de charge réémis par une photodiode en mode photovoltaïque.

Ce pixel génère donc deux signaux d'image : l'un est logarithmique, généré par la photodiode en mode photovoltaïque (Slog) et l'autre linéaire généré par la photodiode en mode intégration (Sint). Ces deux signaux d'images peuvent être exploités de différentes manières dans un capteur d'image muni de tels pixels, dans un système caméra muni de tels capteurs d'images. A titre exemple, le signal Slog peut être utilisé quand il y a une forte dynamique lumineuse dans la scène et le signal Sint quand la scène est sombre. On peut encore combiner ces deux signaux par une formule mathématique fixe ou adaptative afin de fournir une seule image. Il est également possible, si la puissance de traitement permet, faire des combinaisons locales entre ces deux images en fonction des contextes locaux.

Une certaine proximité entre une photodiode opérant en mode photovoltaïque et une photodiode opérant en mode intégration permet bonne une récupération et donc une meilleure accumulation, par une photodiode opérant en mode intégration, des charges photoélectriques émises par une photodiode opérant en mode photovoltaïque.

Cependant, afin de ne pas entraver leur fonctions respectives, la zone de conversion photovoltaïque 2 et la zone d'accumulation de charge 3 sont séparées par une portion de substrat que les porteurs de charge réémis par la première photodiode traversent pour être collectés et accumulés dans la zone d'accumulation, de sorte que la zone de déplétion de la jonction PN de la première photodiode opérant en mode photovoltaïque et la zone de déplétion de la jonction PN de la seconde photodiode sont distinctes et ne se touchent pas.

Ainsi, la distance entre la zone de conversion photovoltaïque 2 de la première photodiode et la zone d'accumulation de charge 3 de la seconde photodiode est comprise entre 0,1 µm et 100 µm, et de préférence encore entre 0,1 µm et 30 µm.

Dans le mode de réalisation illustré par la figure 7, la zone de conversion photovoltaïque 2 et la zone d'accumulation de charge 3 sont superposées de sorte que la zone de conversion photovoltaïque 2 se trouve en surface du substrat 1, tandis que la zone d'accumulation de charge se trouve principalement dans le cœur du substrat 3. Dans ce mode de réalisation, la zone d'accumulation de charge 3 a une extension spatiale couvrant au moins au mois partiellement l'étendue de ladite zone de conversion photovoltaïque 2. De préférence le recouvrement est total, voire dépasse l'étendue de ladite zone de conversion photovoltaïque 2 et ainsi une partie des rayons lumineux peut atteindre, par un trajet direct, la zone de conversion d'accumulation de charge 3 sans avoir traversé la zone de conversion photovoltaïque 2, comme dans le cas illustré par la figure 7.

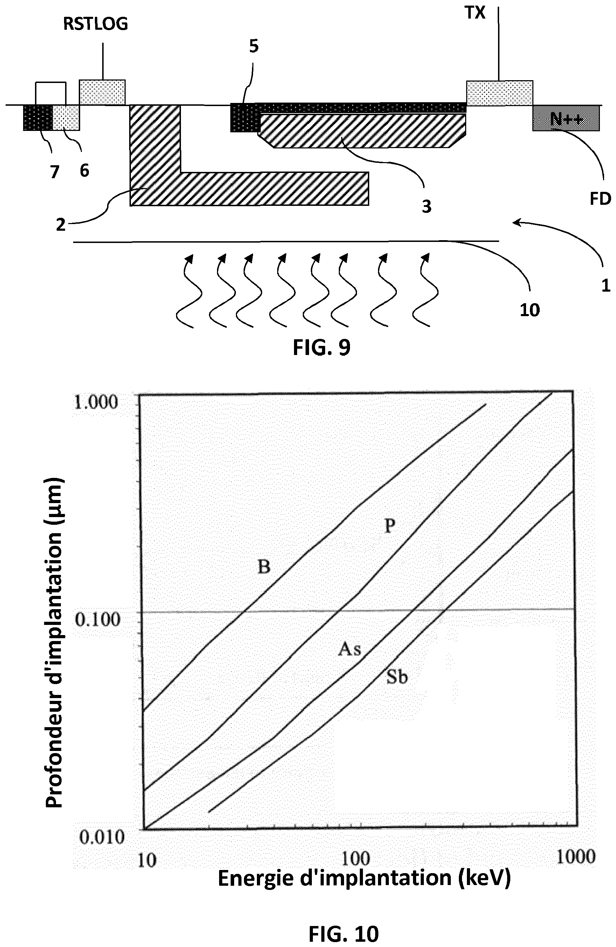

Cette superposition pourrait néanmoins être seulement partielle. C'est notamment dans le cas d'un mode de réalisation dans lequel l'illumination se fait par la face arrière 10 du substrat 1, comme illustrée sur la figure 9. Dans ce cas, la zone de conversion photovoltaïque 2 se trouve principalement dans le substrat 1, tandis que la zone d'accumulation de charge 2 se trouve en surface du substrat 1, bien qu'elle soit isolée de la surface par une zone dopée 5, également appelée zone de passivation, résultant d'une diffusion surfacique généralement d'une très faible profondeur et d'une forte dose du même type que le substrat, par exemple P+ dans le cas d'un substrat de type P, et qui isole la zone d'accumulation 3 de la surface du substrat 1. Dans ce cas également, en raison du caractère non partiel de la superposition, une partie des rayons lumineux atteint, par un trajet direct, la zone de conversion d'accumulation de charge 3 sans avoir traversé la zone de conversion photovoltaïque 2. Le mode de réalisation de la figure 9 reprend sinon les mêmes éléments que celui illustré par la figure 7.

La superposition de la zone de conversion photovoltaïque 2 de la première photodiode et de la zone d'accumulation de charge 3 de la seconde photodiode peut être facilement réalisée par l'homme du métier, en utilisant
- différents niveaux d'énergie pendant l'implantation ionique, et/ou
- par des ions de masses différentes.
Par exemple, pour un dopage de type N, on peut généralement utiliser des ions phosphores (légers) ou des ions arséniques (lourds). La figure 10 montre la profondeur d'implantation en µm de différents ions en fonction de leur énergie cinétique d'implantation en keV.

Par exemple, la zone de conversion photovoltaïque 2 de la photodiode en mode photovoltaïque peut être réalisée par une implantation d'arsénique à 150 keV et la zone d'accumulation de charge 3 de la photodiode en mode intégration par une implantation de phosphore à 800 KeV dans un substrat dopé au bore à 1×10¹⁵ cm⁻². La couche de passivation 5 peut se faire avec une implantation de BF₂ à 10 keV avec une dose de 10¹³ cm⁻². Le livre « Introduction to Semiconductor Manufacturing Technology » écrit par Hong Xiao édité par Prentice Hall (ISBN 0-13-191136-8) donne toute information nécessaire à cette réalisation.

Les structures présentées sur les figures 7 et 9 comportent en outre un transistor de réinitialisation RSTLOG qui est adapté pour connecter une zone de réinitialisation 7 ménagée dans le substrat à la zone de conversion photovoltaïque 2. Par exemple, la zone de réinitialisation 7 est formée par un contact-substrat constitué d'une zone fortement dopée du premier type dans le substrat 1. Le drain 6 du transistor de réinitialisation RSTLOG constitue avec le contact-substrat 7 une jonction PN en court-circuit.

Le substrat 1 peut en outre présenter une modulation spatiale de dopage 8 définissant une zone de contention des porteurs de charge, ladite zone de contention regroupant la première et la seconde photodiode pour contenir les porteurs de charges afin de favoriser l'efficacité de la collecte des porteurs de charge issus de la zone de conversion photovoltaïque 2 par la zone d'accumulation de charge 3. Cette modulation spatiale de dopage 8 permet de contenir les porteurs de charge dans ladite zone de contention, et donc de les contenir dans une zone où ils sont susceptibles d'être collectés par la zone d'accumulation de charge 3. Ainsi, l'exposition de la zone d'accumulation de charge 3 aux porteurs de charge issus de la zone de conversion photovoltaïque 2 est améliorée. Cette modulation de dopage 8 permet également de réduire la diaphonie entre les pixels. La modulation spatiale de dopage est typiquement une zone avec une concentration de dopants supérieure à celle du substrat 1, qui s'étend dans la profondeur du substrat 1 depuis la surface de celui-ci.

La première photodiode et la seconde photodiode peuvent être lues par exemple par deux amplificateurs, ou bien encore par un seul amplificateur muni d'un sélecteur à l'entrée. L'avantage de cette réalisation est le meilleur couplage entre la ou les photodiode(s) en mode cellule solaire et la ou les photodiode(s) en mode intégration. La lecture de la photodiode en mode intégration peut se faire soit en tension directe sur la photodiode (pixel à trois transistors), soit par un transfert de charge sur un nœud de diffusion flottant FD (pixel à quatre transistors), comme présentés précédemment. Les documents EP1354360, US2011/0025898 et EP2186318 présentent également des structures de lecture qui peuvent être employées.

Dans les modes de réalisation illustrés par les figures 7 et 9, la partie lecture de la structure de pixel est similaire à celle présentée sur la figure 3. Un transistor de transfert TX commande et définit dans le substrat 1 un canal de transfert par lequel les porteurs de charge peuvent, depuis la zone d'accumulation de charge 3, atteindre un nœud de diffusion flottant FD, à partir duquel sera effectuée la lecture.

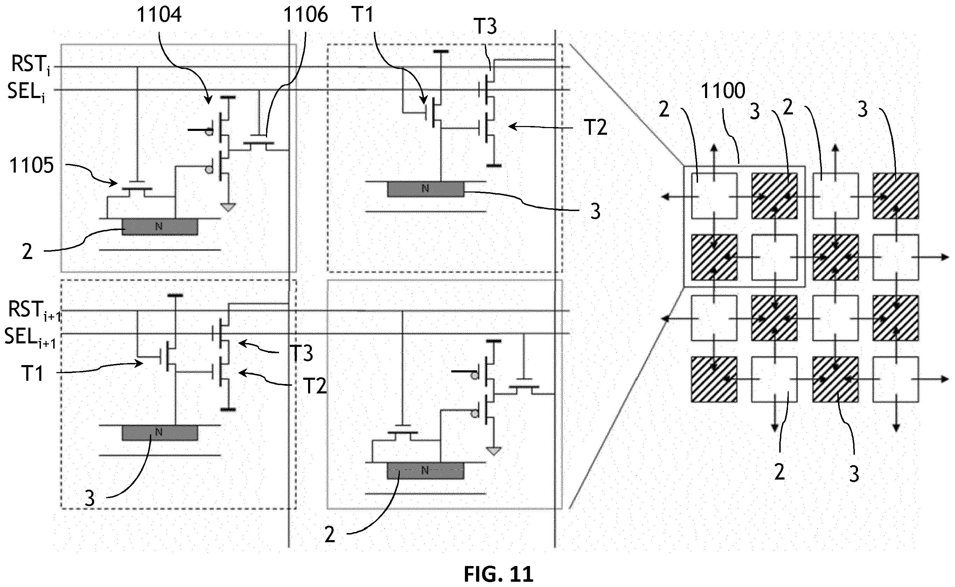

Un autre mode de réalisation présenté par la figure 11 permet d'exploiter des structures existantes et auxquelles l'homme du métier est habitué. Dans cette structure de pixel, la ou les premières photodiodes et la ou les secondes photodiodes sont intercalées entre elles dans le substrat de sorte qu'une zone de conversion photovoltaïque 2 est adjacente à au moins une zone d'accumulation de charge 3.

La figure 11 présente sur sa partie droite une matrice de pixels, et dans sa partie gauche une vue agrandie d'un pixel 1100 comportant deux premières photodiodes opérant en mode photovoltaïque, comprenant chacune une zone de conversion photovoltaïque 2 définie par une zone dopée formant une jonction PN avec le substrat, et deux secondes photodiodes opérant en mode intégration et polarisée en inverse, comprenant chacune une zone d'accumulation de charge 3 définie par une zone dopée formant une jonction PN avec le substrat.

Les moyens de lecture pour lire la tension de la première photodiode et lire une mesure des charges de la seconde photodiode peuvent comprendre un premier circuit pour lire la tension de la première photodiode et un second circuit de lecture pour lire une mesure des charges de la seconde photodiode.

Les premières photodiodes, en mode photovoltaïques, sont chacune lues par un circuit similaire à celui présenté dans le document EP 1 354 360. La jonction PN de la première photodiode est constituée d'un substrat semi-conducteur de type P sur lequel est réalisée une diffusion de type N constituant la zone de conversion photovoltaïque 2.

Un tel circuit comprend un amplificateur tampon 1104 à impédance d'entrée infinie en courant continu, aux bornes d'entrée duquel la jonction PN de la première photodiode est reliée. L'amplificateur tampon 1104 est réalisé par deux transistors à effet de champ MOS à canal P en série, alimentés par une tension d'alimentation, le premier transistor joue un rôle de source de courant de polarisation, avec sa grille connectée sur une tension permettant d'ajuster ce courant de polarisation.

Le circuit comporte en outre un interrupteur 1105 apte à sélectivement créer un court-circuit de la jonction PN pour simuler une condition d'obscurité. L'interrupteur 1105 ainsi que l'interrupteur de sélection 1106 sont constitués par des transistors à effet de champ MOS à canal N.

Les secondes photodiodes, en mode intégration, sont chacune lues par un circuit à trois transistors tel que précédemment présenté.

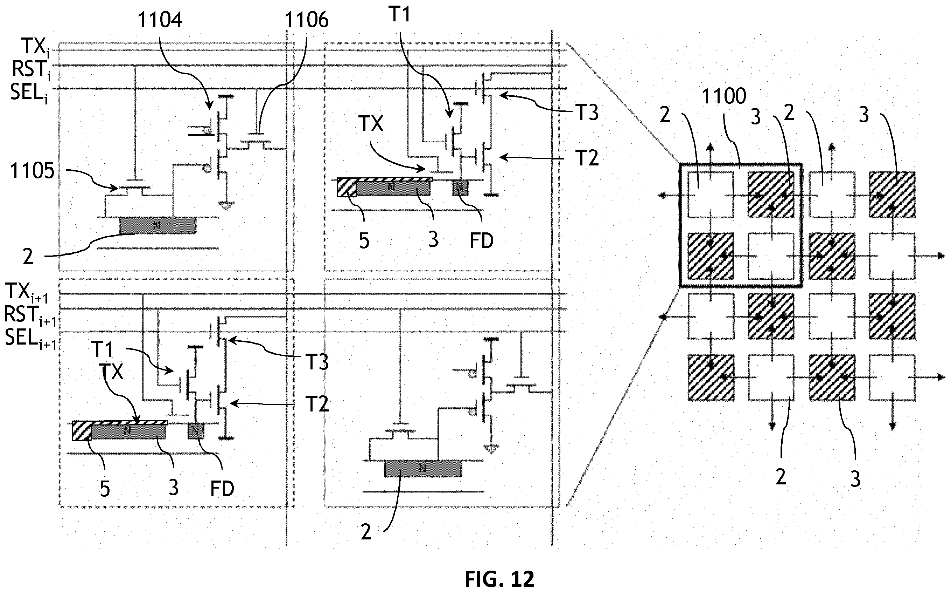

La figure 12 montre une variante de ce mode de réalisation avec des photodiodes en mode intégration à quatre transistors, les circuits associés aux photodiodes en mode photovoltaïques restant les mêmes. Ce circuit à quatre transistors fonctionne de manière similaire à celui décrit pour la figure 3, avec un transistor de transfert TX commandant et définissant un canal de transfert de charge entre la zone d'accumulation de charge 3 de la photodiode opérant en mode intégration et un nœud de diffusion flottant FD. Ce transistor de transfert TX est commandé au moyen d'un signal de transfert TXᵢ.

La tension au niveau du nœud de diffusion flottant FD est lue au moyen d'un transistor de lecture T2 dont la grille est connectée au nœud de diffusion flottant FD.

Un transistor de sélection T3 commandé sur sa grille au moyen d'un signal de sélection SELᵢ permet de sélectivement transmettre la lecture de la photodiode à un bus COLⱼ. Un transistor d'initialisation T1 commandé sur sa grille au moyen d'un signal d'initialisation RSTᵢ permet d'initialiser la tension du nœud de diffusion flottant FD à une tension d'initialisation.

Ces deux modes de réalisation fonctionnent de manière similaire. Les premières photodiodes réémettent des porteurs de charge photoélectrique captée par la jonction PN lors de l'exposition de ladite première photodiode à un rayonnement. Les secondes photodiodes comprennent une zone d'accumulation de charge définie par une zone dopée formant une jonction PN avec le substrat, ladite zone d'accumulation de charge étant exposée aux porteurs de charge issus de la zone de conversion photovoltaïque pour accumuler de tels porteurs de charge. Cette circulation des porteurs de charge est symbolisée par des flèches dans la partie droite des figures 11 et 12.

Compte tenu de la faible taille d'un pixel, la charge photoélectrique relâchée par une photodiode en cellule solaire, i.e. photovoltaïque, pourrait facilement traverser plusieurs pixels. Par exemple, dans un substrat silicium de type P dopé à 1×10¹⁵ cm⁻³, la longueur de diffusion de charge mobile peut aller à plusieurs centaines de micromètres, tandis que la plupart des pixels ont une dimension inférieure à 10 µm x 10 µm. Dans ce cas, une solution simple est d'agencer deux populations de photodiodes dans un pixel, ou alternativement deux populations de pixels constitués chacun d'un type de photodiode, en une matrice, de sorte que les charges libérées par les pixels en mode cellule solaire soient captées latéralement les pixels en mode intégration situés à proximité, de préférence de manière adjacente, c'est-à-dire qu'ils en sont les plus proches voisins.

A la sortie d'une telle matrice, on dispose alors de deux sous-images : une sous-image logarithmique provenant des photodiodes en mode cellule solaire et une sous-image linéaire provenant des photodiodes en mode intégration.

Il faut faire particulièrement attention à la saturation des photodiodes en mode intégration. Si on laisse la seconde photodiode en mode intégration accumuler trop de charge, la seconde photodiode finit par entrer à son tour en mode photovoltaïque, dit également mode cellule solaire, et entache les secondes photodiodes voisines des pixels voisins.

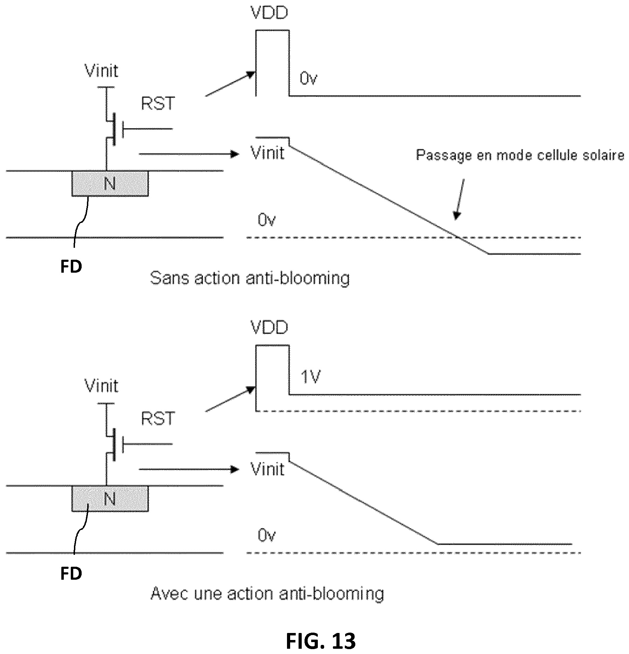

Par conséquent, la fonction dite anti-blooming doit être activée de préférence dans les photodiodes en mode intégration afin d'empêcher celles-ci d'entrer en mode photovoltaïque. Avec un circuit à trois transistors tel que dans la figure 11, l'action anti-blooming se fait simplement par la forme d'onde utilisée pour le signal d'initialisation RST. La figure 13 montre le principe de l'action anti-blooming via le signal RST. Elle consiste simplement à commander le transistor d'initialisation avec un signal de reset RST qui présente un niveau bas (dans le cas d'un transistor d'initialisation à canal de type N) qui soit non nul, au lieu d'être à zéro, lorsque le transistor d'initialisation T1 n'est pas activé. Dans l'exemple de la figure 13, le signal RST est maintenu supérieur ou égal à 1V, de sorte que la tension au niveau du nœud de diffusion flottant FD ne devient pas négative. Dans ce cas, la charge en excès créée par la photodiode en mode intégration est drainée par le transistor d'initialisation T1 vers l'alimentation.

La fonction anti-blooming pour les photodiodes à quatre transistors est également de préférence mise en oeuvre afin d'éviter le blooming dans une matrice. L'article technique « Implementation global shutter in a 4T pixel » par A. Krymski dans la conférence International Image Sensor Workshop en 2009 donne une description du phénomène blooming dans un pixel en mode intégration à quatre transistors et aussi une méthode efficace pour l'éviter. De même, les brevets US7897904, US8093541 et US6777662 donnent des solutions à base d'un cinquième transistor afin de drainer les charges en excès vers l'alimentation.

Les modes de réalisation précédemment décrits font appel à un mixage fonctionnel entre les photodiodes en mode cellule solaire et celles en mode intégration. Ces modes de réalisation présentent l'avantage majeur de pouvoir exploiter des structures existantes et validées. Cependant, un inconvénient réside dans le fait que la résolution spatiale d'une matrice de photodiodes est divisée par deux pour chaque mode de fonctionnement, en comparaison avec les structures superposées précédemment décrites. En outre, les circuits de lecture des photodiodes restent indépendants et non-optimisés. Le nombre total de transistors pour un pixel composé (en mode cellule solaire et en mode intégration) peut ainsi dépasser dix transistors, ce qui entraîne des problèmes d'encombrements et de coût.

Le mode de réalisation propose une refonte des circuits de lecture à la fois pour la photodiode en mode cellule solaire et pour la photodiode en mode intégration. Compte tenu de la performance en bas niveau de lumière, la description qui suit est restreinte à des structures faisant appel à une photodiode PPD avec un transfert de charge.

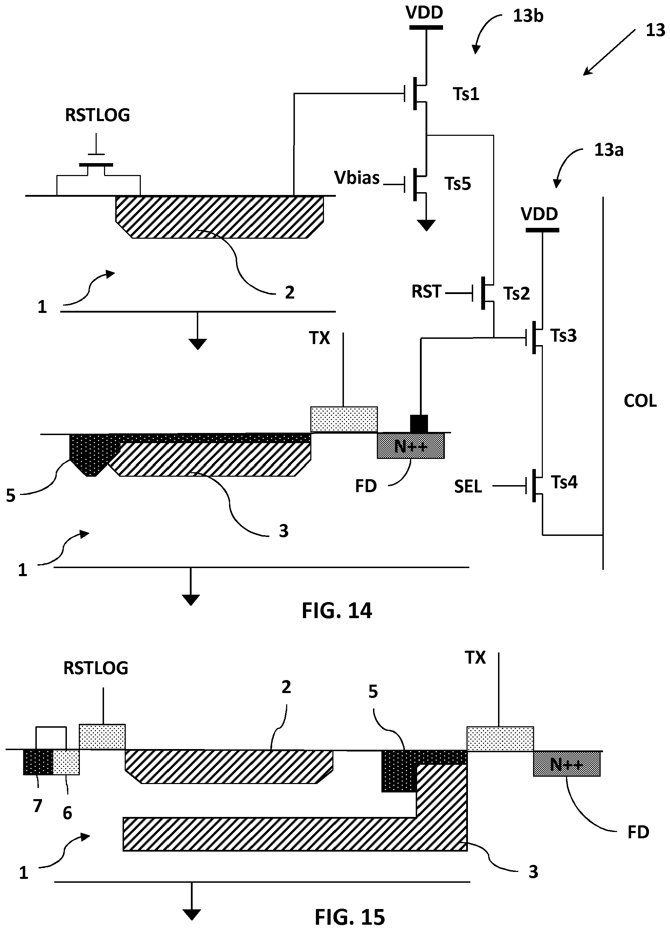

La figure 14 illustre le schéma électrique d'un mode de réalisation possible d'une structure de pixel selon l'invention, tandis que la figure 15 illustre une vue en coupe de l'agencement entre la première photodiode et la seconde photodiode de ce mode de réalisation.

La configuration des photodiodes de cette structure de pixel de ce mode de réalisation est similaire à celle de la figure 7, mais il ne s'agit que d'un exemple non limitatif, d'autres configurations telles que celles de la figure 9, ou encore des figures 11 et 12, peuvent être utilisées.

Ainsi, dans le mode de réalisation illustré par les figures 14 et 15, la structure d'un pixel actif de type CMOS comprend
- un substrat semi-conducteur 1 d'un premier type,
- au moins une première photodiode opérant en mode photovoltaïque comprenant une zone de conversion photovoltaïque 2 définie par une zone dopée d'un second type formant une jonction PN avec le substrat, ladite première photodiode réémettant des porteurs de charge photoélectriques captées par la jonction PN lors de l'exposition de ladite première photodiode à un rayonnement,
- au moins une seconde photodiode opérant en mode intégration et polarisée en inverse, ladite seconde photodiode comprenant une zone d'accumulation de charge 3 définie par une zone dopée du second type formant une jonction PN avec le substrat, ladite zone d'accumulation de charge étant exposée aux porteurs de charge issus de la zone de conversion photovoltaïque 2 pour accumuler de tels porteurs de charge.

Dans l'exemple illustré, la zone de conversion photovoltaïque 2 et la zone d'accumulation de charge 3 sont superposées dans le substrat 1. Une zone dopée 5, également appelée zone de passivation, résultant d'une diffusion surfacique d'une très faible profondeur et d'une forte dose du même type que le substrat, par exemple de type P, isole la zone d'accumulation de charge 3 de la surface du substrat 1.

Au lieu d'un premier circuit pour lire la tension de la première photodiode et d'un second circuit de lecture pour lire une mesure des charges de la seconde photodiode, les moyens de lecture pour lire la tension de la première photodiode et lire une mesure des charges de la seconde photodiode peuvent comprendre un circuit de lecture commun 13 au niveau du pixel.

La première photodiode et la seconde photodiode possèdent ainsi un circuit de lecture commun 13 au niveau du pixel connecté à un bus COL commun pour lire la tension de la première photodiode et lire une mesure des charges de la seconde photodiode.

Les transistors de ce circuit de lecture commun 13 sont de préférence tous des transistors de type N. En effet, les transistors de type P sont plus volumineux que ceux de type N, et leur utilisation rendrait donc plus encombrant le pixel. En outre, l'absorption des porteurs de charge par la zone d'accumulation de charge 3 permet de se passer d'un caisson d'isolation et d'utiliser des transistors de type N pour réduire l'encombrement du circuit de lecture, et donc du pixel.

Le circuit de lecture commun 13 comprend :
- une structure à transfert de charge 13a adaptée pour lire la tension d'un nœud de diffusion flottant associé à la seconde photodiode,
- un circuit de décalage de tension 13b connectant la première photodiode au nœud de diffusion flottant par l'intermédiaire d'un transistor d'initialisation Ts2 de la structure à transfert de charge 13a.

Dans l'exemple illustré par la figure 14, le circuit de décalage de tension 13b comporte un transistor Ts1 de type N à tension de seuil négative dont la grille est reliée à la zone de conversion photovoltaïque 2, et un autre transistor Ts5 de type N dont la grille est polarisée par une tension Vbias. Le transistor Ts1 possède un drain relié à une tension d'alimentation VDD, et sa source est connectée au drain de l'autre transistor Ts5 et au drain du transistor d'initialisation Ts2 appartenant à la structure à transfert de charge 13a.

Cette structure à transfert de charge 13a comprend donc le transistor Ts2, commandé sur sa grille par un signal d'initialisation RST et par lequel ladite structure à transfert de charge 13a est connectée au circuit de décalage de tension 13b. La structure à transfert de charge 13a comprend également un transistor de lecture Ts3 de type N, également appelé amplificateur suiveur, dont la grille est connectée à la source du transistor d'initialisation Ts2 et au nœud de diffusion flottant FD. Un transistor de transfert TX de type N permet de transférer la charge depuis la zone d'accumulation de charge 3 vers le nœud de diffusion flottant FD. Enfin, la source du transistor de lecture Ts3 est connectée au drain du transistor de sélection Ts4 par lequel le circuit de lecture 13 peut être connecté au bus de lecture COL.

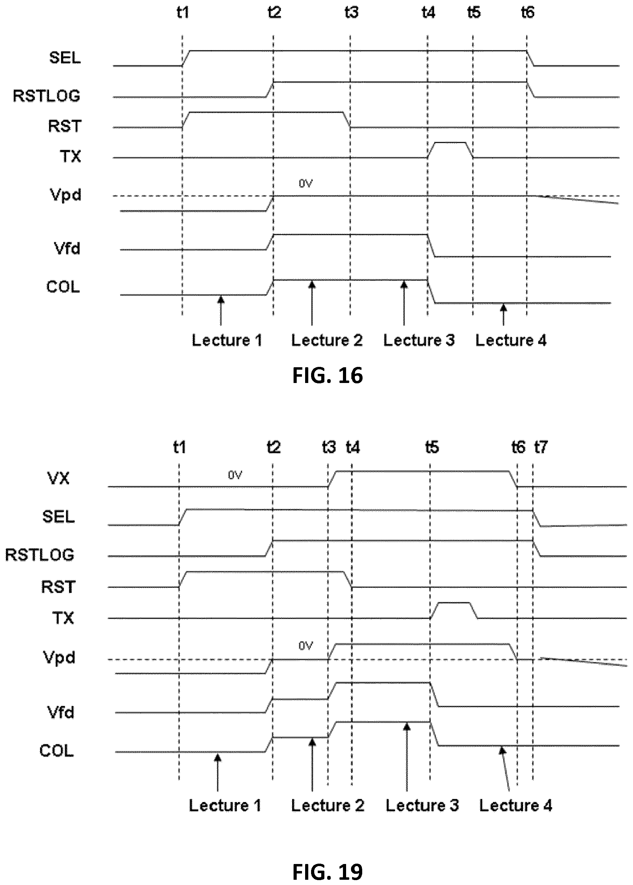

Le fonctionnement de cette structure de pixel est décrit à l'aide du chronogramme schématisé par la figure 16. Le signal de sélection SEL est appliqué à la grille du transistor de sélection de Ts4 de type N, le signal d'initialisation de la zone de conversion photovoltaïque RSTLOG s'applique à la grille du transistor de réinitialisation de la zone de conversion photovoltaïque 2, le signal d'initialisation RST s'applique à la grille du transistor Ts2 de type N, le signal de transfert TX s'applique à la grille du transistor de transfert TX de type N. La tension Vpd correspond à la tension au niveau de la zone de conversion photovoltaïque 2, la tension Vfd correspond à la tension au niveau du nœud de diffusion flottant, et la tension COL correspond à la tension sur le bus COL commun.

Au temps t1, le signal de sélection SEL est activé (positionné en niveau haut), le transistor de sélection Ts4 devient passant, et le transistor amplificateur suiveur Ts3 est connecté au bus de lecture COL. En même temps, le signal d'initialisation RST est également positionné en niveau haut. Sachant que le transistor de transfert TX est désactivé, le nœud de diffusion flottant FD est connecté sur la sortie du buffer de lecture de la première photodiode en mode photovoltaïque constitué par le circuit de décalage de tension 13b. Une première lecture est alors effectuée sur le bus de lecture COL (Lecture1).

Ensuite, au temps t2, le signal d'initialisation RSTLOG de la zone de conversion photovoltaïque 2 est activé au niveau haut, la photodiode en mode photovoltaïque est alors court-circuitée et une seconde lecture est faite (Lecture2). La différence entre Lecture1 et Lecture2 donne la réponse logarithmique de la photodiode en mode photovoltaïque.

Au temps t3, le signal d'initialisation RST est désactivé, c'est-à-dire passé en niveau bas, et le nœud de diffusion flottant FD devient isolé. Une troisième lecture est faite pour prélever le niveau de reset sur le nœud diffusion flottant FD (Lecture3).

Au temps t4, la charge photoélectrique accumulée sur la seconde photodiode en mode intégration est transférée vers le nœud de diffusion flottant FD par l'action du transistor de transfert TX. Ce transfert de charge provoque une chute de tension sur le nœud de diffusion flottant FD.

Au temps t5, le transistor de transfert est désactivé et une quatrième lecture (Lecture 4) est faite pour mesurer la tension au niveau du nœud de diffusion flottant FD. La différence entre Lecture 3 et Lecture 4 donne une réponse linéaire de la seconde photodiode. Enfin, à t6, les signaux RSTLOG et SEL sont remis en niveau bas, et l'exposition recommence.

Dans le mode de réalisation illustré par les figures 14 et 15, les photodiodes sont superposées. La première photodiode, en mode photovoltaïque, est implantée avec des ions à faible profondeur et la seconde photodiode, en mode intégration, est implantée à une profondeur plus importante dans le substrat. Le traitement des lectures de ces photodiodes est similaire aux modes de réalisation précédents. Cette structure peut exiger des modifications mineures d'un procédé CMOS standard, mais présente bien plus d'avantages, et notamment un meilleur couplage entre les deux types de photodiodes et une plus grande compacité du pixel, permettant d'envisager une meilleure résolution.

Dans cette configuration, le transistor Ts1 doit posséder une tension de seuil négative (transistor à déplétion) afin de générer une tension positive à la sortie du buffer, i.e. du circuit de décalage de tension 13b. Cette tension de seuil doit être suffisamment négative pour que, lorsque la première photodiode, en mode photovoltaïque, est court-circuitée, on retrouve une tension adéquate pour la réinitialisation du nœud de diffusion flottant FD.

Le transistor Ts2, quand il est passant, doit avoir une tension de seuil permettant une transmission de la sortie du buffer, i.e. du circuit de décalage de tension 13b, vers le nœud de diffusion flottant FD. Le transistor Ts3 doit avoir une tension de seuil adéquate afin de pouvoir recopier la tension du nœud de diffusion flottant FD vers le bus COL avec une bonne linéarité. Ces tensions de seuil peuvent être obtenues par une implantation ionique supplémentaire sur ces transistors.

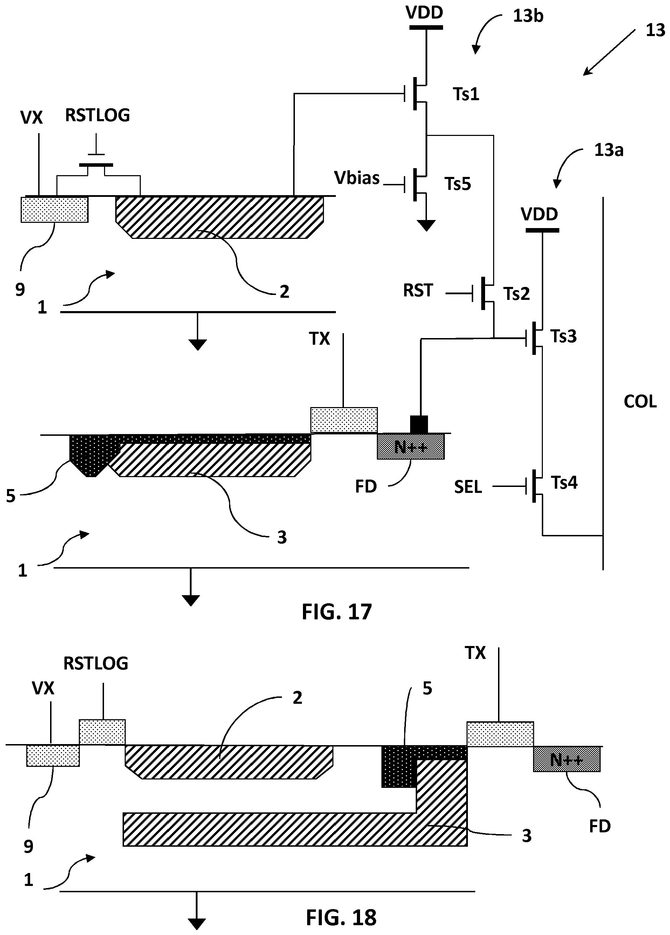

Néanmoins, la complexité d'ajustement des tensions de seuil des transistors Ts1, Ts2 et Ts3 peut être réduite par l'introduction d'une tension de polarisation variable VX au sein du pixel comme le montre les figures 17 et 18. Sur ces figures sont respectivement illustrées le schéma électrique et une vue en coupe de l'agencement des zones de la structure de pixel selon un mode de réalisation de l'invention.

Ce mode de réalisation est similaire à celui précédemment décrit en référence aux figures 14 et 15, à l'exception du remplacement de la structure de court-circuitage de la zone de conversion photovoltaïque 2. En effet, celle-ci est remplacée par un nœud 9 auquel une tension VX est appliquée. Ce nœud 9 peut être connecté à la zone de conversion photovoltaïque 2 au moyen du transistor d'initialisation RSTLOG de ladite zone de conversion photovoltaïque 2. Ce nœud 9 est constitué d'une zone fortement dopée du second type, ici du type N, polarisée par la tension variable Vx, formant la zone de réinitialisation. La connexion de ce nœud 9 à la zone de conversion photovoltaïque 2 permet de propager ladite tension variable Vx jusqu'au nœud de diffusion flottant FD associé à la zone d'accumulation de charge 3.

Le fonctionnement de cette structure est très proche de celui de la structure des figures 14 et 15, et son chronogramme de fonctionnement illustré par la figure 19 est donc logiquement très proche de celui de la figure 16. Par conséquent, seules les différences seront mentionnées ici.

Ainsi, dans cette configuration, la tension variable VX passe à une valeur au-dessus de 0 V après t3 et retombe à 0 V après un temps t6 intervenant avant la désactivation des signaux SEL et RSTLOG au temps t7. C'est-à-dire que la tension variable VX reste à la valeur de la masse pendant la lecture de la première photodiode, en mode photovoltaïque, et passe à une valeur supérieure pendant la lecture de la seconde photodiode, en mode intégration. La tension variable VX permet ainsi de précharger le nœud de diffusion flottant FD à une tension facilitant la lecture de la seconde photodiode. L'ajout de cette tension variable VX donne donc plus de souplesse dans le choix des tensions de seuil pour les transistors Ts1, Ts2 et Ts3.

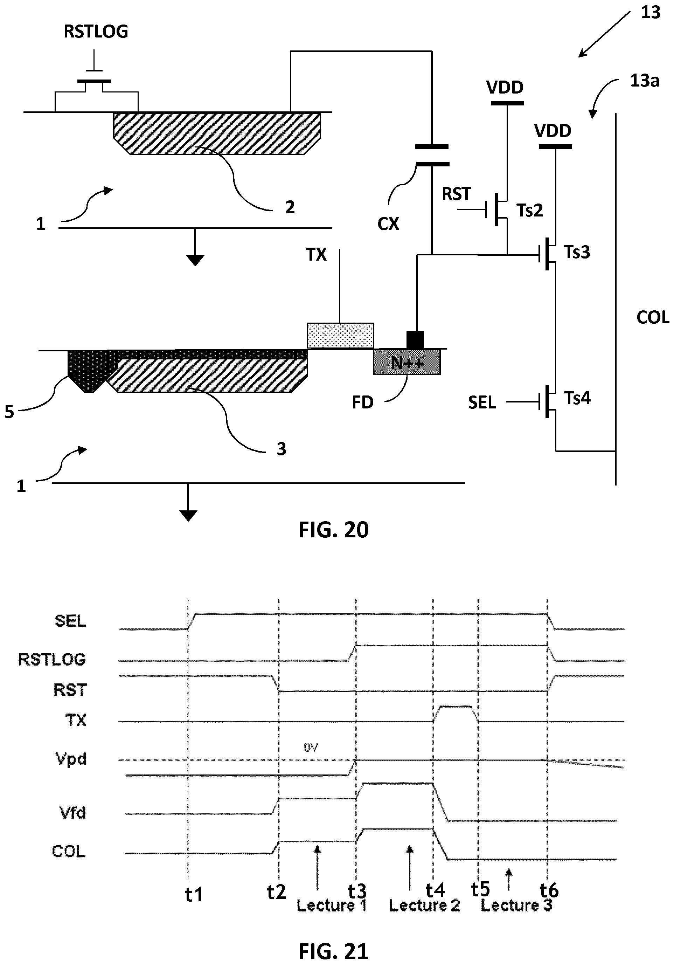

La figure 20 donne une autre variante permettant d'éviter ce problème de choix des tensions de seuil pour les transistors Ts1, Ts2 et Ts3. Dans cette variante, la structure reste similaire à celles précédemment présentées, sauf que la zone de conversion photovoltaïque 2 est connectée au nœud de diffusion flottant par un condensateur CX au lieu d'un circuit de décalage de tension. Une autre borne dudit condensateur CX est reliée au nœud de diffusion flottant FD. Le condensateur CX peut être réalisé soit comme une structure séparée de la première photodiode en mode photovoltaïque, soit par une grille au-dessus de cette première photodiode.

La figure 21 illustre le chronogramme de fonctionnement du mode de réalisation de la figure 20. Pendant l'exposition du pixel, le signal RST est maintenu à un niveau haut, i.e. niveau « 1 ». Après que le pixel soit sélectionné par l'activation du signal SEL au temps t1, le signal RST est désactivé au temps t2. Une première lecture (Lecture 1) sur le bus COL prélève alors la tension de reset sur le nœud de diffusion flottant FD.

Ensuite la première photodiode, en mode photovoltaïque également appelé mode cellule solaire, est court-circuitée par l'application du signal RSTLOG au temps t3. La variation de la tension sur cette première photodiode, correspondant à un signal logarithmique en fonction de la lumière, est transmise vers le nœud de diffusion flottant FD via le condensateur CX. Une seconde lecture (Lecture2) est alors effectuée sur le bus COL.

La différence entre ces deux lectures (lecture 1 - lecture 2) donne la réponse logarithmique du pixel. Sachant que cette variation est toujours dans le sens positif, il n'est donc pas nécessaire de refaire l'initialisation, ou reset, du nœud de diffusion flottant FD.

On actionne le signal TX au temps t4. La charge photoélectrique transmise de la seconde photodiode fait chuter la tension sur le nœud de diffusion flottant FD. Au temps t5, le transistor de transfert TX est désactivé et une troisième lecture est faite (Lecture 3) sur le bus COL. La différence entre Lecture2 et Lecture3 donne la réponse linéaire du pixel. Enfin, à t6, les signaux RSTLOG et SEL sont remis en niveau bas, le signal RST en niveau haut, et l'exposition recommence.

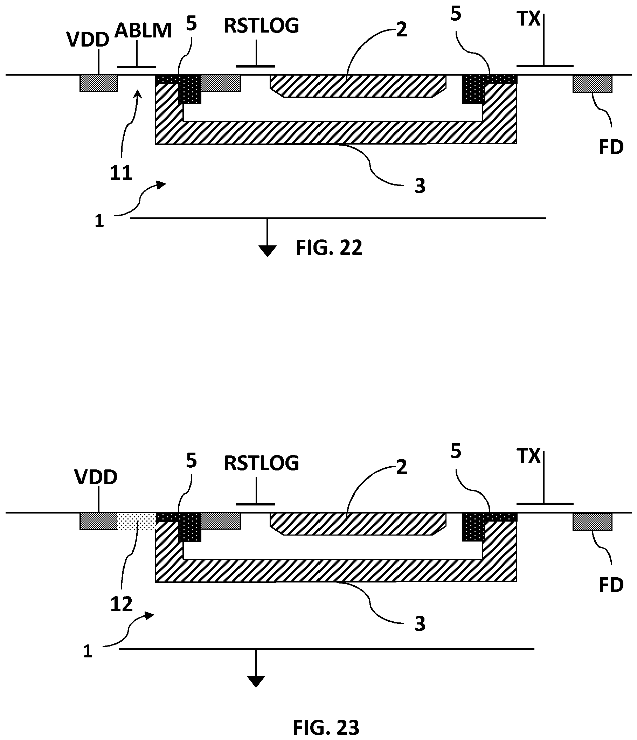

Pour toutes les réalisations avec une seconde photodiode à transfert de charge, il est avantageux de prévoir une structure anti-blooming, différente de celle dans un pixel à quatre transistors. Les figures 22 et 23 montrent deux structures d'anti-blooming compatibles avec une seconde photodiode comportant une zone fortement dopée 5 du même type que le substrat isolant la zone d'accumulation 3 de ladite seconde photodiode de la surface du substrat.

Les figures 22 et 23 sont des coupes illustrant la configuration empilée des différentes zones de la structure. La zone de conversion photovoltaïque 2 est entourée par la zone d'accumulation de charge 3, tant latéralement que dans la profondeur du substrat. Une telle configuration peut d'ailleurs être envisagée pour les autres modes de réalisation pour maximiser la récupération des porteurs de charge.

Dans la figure 22, un transistor anti-blooming 11 est disposé entre un nœud à une tension VDD et la zone d'accumulation 3. La modulation de la tension ABLM appliquée à sa grille permet d'empêcher la diffusion des porteurs de charge en dehors de la zone d'accumulation de charge 3 de la seconde photodiode. En variante, dans la figure 23, c'est une zone 12 dopée N qui remplace le transistor anti-blooming 11, et ce dopage crée un chemin de passage privilégié pour les porteurs de charges débordant de la zone d'accumulation de charge 3.

Les différents modes de réalisation qui ont été présentés peuvent être combinés à loisir en fonction de leur faisabilité, et des éléments présentés dans l'état de la technique peuvent également être incorporés à des modes de réalisation particuliers.

Par exemple, une structure selon l'invention peut présenter la structure doublée de la figure 5. De même, la variante exposée à la figure 7 peut trouver à s'appliquer dans les autres modes de réalisation.

De même, dans les exemples présentés, le substrat est de type P, et la zone de conversion photovoltaïque 2, ainsi que la zone d'accumulation de charge 3 et le nœud de diffusion flottant FD sont de type N. Cependant, d'autres configurations peuvent être employées, bien que celle-ci soit préférée.

L'invention concerne également un capteur comprenant
- une pluralité de structure de pixels selon l'invention, de préférence organisées en une matrice, et
- au moins un circuit de sortie combinant la lecture de la tension de la première photodiode et la lecture d'une mesure des charges de la seconde photodiode.

La combinaison de ces lectures peut par exemple être l'addition, des opérations plus complexes, ou encore simplement le basculement de l'une vers l'autre en fonction des conditions d'expositions.

## Revendications

1. Structure d'un pixel actif de type CMOS, comprenant
- un substrat semi-conducteur (1) d'un premier type,
- au moins une première photodiode configurée pour opérer en mode photovoltaïque lors de l'exposition de ladite première photodiode à un rayonnement comprenant une zone de conversion photovoltaïque (2) définie par une zone dopée d'un second type formant une jonction PN avec le substrat, ladite première photodiode étant configurée pour réémettre des porteurs de charge photoélectriques captées par la jonction PN lors de l'exposition de ladite première photodiode à un rayonnement,
- au moins une seconde photodiode configurée pour opérer en mode intégration et être polarisée en inverse lors de l'exposition de ladite première photodiode à un rayonnement, ladite seconde photodiode comprenant une zone d'accumulation de charge (3) définie par une zone dopée du second type formant une jonction PN avec le substrat, ladite zone d'accumulation de charge étant configurée pour être exposée aux porteurs de charge issus de la zone de conversion photovoltaïque (2) pour accumuler de tels porteurs de charge, et
- des moyens de lecture pour lire la tension de la première photodiode et lire une mesure des charges de la seconde photodiode comprenant un circuit de lecture commun (13) à la première photodiode et à la seconde photodiode, au niveau du pixel, connecté à un bus COL commun pour lire la tension de la première photodiode et lire une mesure des charges de la seconde photodiode.

2. Structure selon la revendication précédente, dans laquelle la zone de conversion photovoltaïque (2) et la zone d'accumulation de charge (3) sont séparées par une portion de substrat que les porteurs de charge réémis par la première photodiode traversent pour être collectés et accumulés dans la zone d'accumulation, de sorte que la zone de déplétion de la jonction PN de la première photodiode et la zone de déplétion de la jonction PN de la seconde photodiode sont distinctes et ne se touchent pas.

3. Structure selon l'une des revendications précédentes, dans laquelle le substrat (1) présente une modulation spatiale de dopage (8) définissant une zone de contention des porteurs de charge, ladite zone de contention regroupant la première et la seconde photodiode.

4. Structure selon l'une des revendications 2 à 3, dans laquelle la distance entre la zone de conversion photovoltaïque (2) et la zone d'accumulation de charge (3) est comprise entre 0,1 µm et 100 µm.

5. Structure selon l'une des revendications précédentes, dans laquelle la ou les premières photodiodes et la ou les secondes photodiodes sont intercalées entre elles dans le substrat de sorte qu'une zone de conversion photovoltaïque (2) est adjacente à au moins une zone d'accumulation de charge (3).

6. Structure selon l'une des revendications précédentes, dans laquelle la zone de conversion photovoltaïque (2) et la zone d'accumulation de charge (3) sont au moins partiellement superposées.

7. Structure selon la revendication précédente, dans laquelle la zone d'accumulation de charge (3) a une extension spatiale couvrant au moins l'étendue de ladite zone de conversion photovoltaïque (2).

8. Structure selon l'une des revendications précédentes, dans laquelle la seconde photodiode comprend une couche de passivation présentant un dopage de même type que le substrat et séparant la zone d'accumulation de charge (3) d'une surface du substrat.

9. Structure selon l'une des revendications précédentes, dans laquelle un transistor de réinitialisation (RSTLOG) est adapté pour connecter une zone de réinitialisation ménagée dans le substrat (1) à la zone de conversion photovoltaïque (2).

10. Structure selon la revendication précédente, dans laquelle la zone de réinitialisation est formée par un contact-substrat (7) constitué d'une zone fortement dopée du premier type dans le substrat (1).

11. Structure selon la revendication 9, dans laquelle la zone de réinitialisation est constituée d'une zone fortement dopée polarisée par une tension variable Vx, afin de propager ladite tension variable Vx jusqu'au nœud de diffusion flottant (FD) associé à la zone d'accumulation de charge (3).

12. Structure selon l'une des revendications précédentes, comprenant un nœud de diffusion flottant (FD) associé à la zone d'accumulation de charge (3), dans laquelle le circuit de lecture commun (13) comprend :
- une structure à transfert de charge (13a) adaptée pour lire la tension d'un nœud de diffusion flottant associé à la seconde photodiode,
- un circuit de décalage de tension (13b) connectant la première photodiode au nœud de diffusion flottant (FD) par l'intermédiaire d'un transistor d'initialisation (Ts1) de la structure à transfert de charge.

13. Structure selon la revendication précédente, dans laquelle le circuit de décalage de tension (13b) comporte un transistor à tension de seuil négative (Ts1) dont la grille est reliée à la zone de conversion photovoltaïque (2).

14. Structure selon la revendication 11, comprenant un nœud de diffusion flottant (FD) associé à la zone d'accumulation de charge (3), dans laquelle le circuit de lecture commun (13) comprend une structure à transfert de charge (13a) adaptée pour lire la tension d'un nœud de diffusion flottant associé à la seconde photodiode, et dans laquelle la zone de conversion photovoltaïque (2) est connectée au nœud de diffusion flottant par un condensateur (CX).

15. Capteur comprenant
- une pluralité de structure de pixel selon l'une des revendications 1 à 14,
- au moins un circuit de sortie combinant la lecture de la tension de la première photodiode et la lecture d'une mesure des charges de la seconde photodiode.

16. Procédé de fonctionnement d'un pixel actif de type CMOS présentant une structure selon l'une quelconque des revendications 1 à 14, dans lequel
- la première photodiode opère en mode photovoltaïque et réémet des porteurs de charges photoélectriques captées par la jonction PN lors de l'exposition de ladite première photodiode à un rayonnement,
- la seconde photodiode est polarisée en inverse et opère en mode intégration, ladite zone d'accumulation de charge étant exposée aux porteurs de charge issus de la zone de conversion photovoltaïque pour accumuler de tels porteurs de charge,
- la tension de la première photodiode et une mesure des charges de la seconde photodiode sont lues par un circuit de lecture commun (13) à la première photodiode et à la seconde photodiode, au niveau du pixel, connecté à un bus COL commun pour lire la tension de la première photodiode et lire une mesure des charges de la seconde photodiode.

## Patentansprüche

1. Struktur eines aktiven CMOS-Pixels, umfassend
- ein Halbleitersubstrat (1) eines ersten Typs,
- mindestens eine erste Photodiode, konfiguriert, um beim Aussetzen der ersten Photodiode einer Strahlung, die eine Photovoltaik-Umwandlungszone (2) umfasst, die durch eine Zone definiert wird, die mit einem zweiten Typ dotiert ist, der einen PN-Anschluss an das Substrat bildet, im Photovoltaik-Modus zu wirken, wobei die erste Photodiode konfiguriert ist, um photoelektrische Lastenträger, die durch den PN-Anschluss beim Aussetzen der ersten Photodiode einer Strahlung erfasst werden, neu zu senden,
- mindestens eine zweite Photodiode, konfiguriert, um im Integrationsmodus zu wirken, und beim Aussetzen der ersten Photodiode einer Strahlung in Sperrrichtung polarisiert zu werden, wobei die zweite Photodiode eine Lastansammlungszone (3) umfasst, die durch eine dotierte Zone des zweiten Typs definiert wird, die einen PN-Anschluss an das Substrat bildet, wobei die Lastansammlungszone konfiguriert ist, um den Lastenträgern ausgesetzt zu werden, die aus der Photovoltaik-Umwandlungszone (2) stammen, um solche Lastenträger anzusammeln, und
- Lesemittel zum Lesen der Spannung der ersten Photodiode und Lesen einer Messung der Lasten der zweiten Photodiode, eine gemeinsame Leseschaltung (13) der ersten Photodiode und der zweiten Photodiode im Bereich des Pixels umfassend, die mit einem gemeinsamen COL Bus verbunden ist, um die Spannung der ersten Photodiode zu lesen und eine Messung der Lasten der zweiten Photodiode zu lesen.

2. Struktur nach dem vorstehenden Anspruch, wobei die Photovoltaik-Umwandlungszone (2) und die Lastansammlungszone (3) durch einen Substratabschnitt getrennt sind, den die Lastenträger, die durch die erste Photodiode neu gesendet werden, durchqueren, um erhoben und in der Ansammlungszone angesammelt werden, sodass die Raumladungszone des PN-Anschlusses der ersten Photodiode und die Raumladungszone des PN-Anschlusses der zweiten Photodiode unterschiedlich sind und sich nicht berühren.

3. Struktur nach einem der vorstehenden Ansprüche, wobei das Substrat (1) eine räumliche Dotiermodulation (8) präsentiert, die eine Enthaltungszone der Lastenträger definiert, wobei die Enthaltungszone die erste und die zweite Photodiode zusammenfasst.

4. Struktur nach einem der Ansprüche 2 bis 3, wobei der Abstand zwischen der Photovoltaik-Umwandlungszone (2) und der Lastansammlungszone (3) zwischen 0,1 µm und 100 µm enthalten ist.

5. Struktur nach einem der vorstehenden Ansprüche, wobei die erste oder ersten Photodioden und die zweite oder zweiten Photodioden in dem Substrat dazwischen gesetzt sind, sodass eine Photovoltaik-Umwandlungszone (2) an mindestens eine Lastansammlungszone (3) angrenzend ist.

6. Struktur nach einem der vorstehenden Ansprüche, wobei die Photovoltaik-Umwandlungszone (2) und die Lastansammlungszone (3) mindestens teilweise überlagert sind.

7. Struktur nach dem vorstehenden Anspruch, wobei die Lastansammlungszone (3) eine räumliche Erweiterung aufweist, die mindestens die Ausdehnung der Photovoltaik-Umwandlungszone (2) abdeckt.

8. Struktur nach einem der vorstehenden Ansprüche, wobei die zweite Photodiode eine Passivierungsschicht umfasst, die eine Dotierung eines selben Typs wie das Substrat präsentiert und die Lastansammlungszone (3) von einer Oberfläche des Substrats trennt.

9. Struktur nach einem der vorstehenden Ansprüche, wobei ein Reset-Transistor (RSTLOG) ausgeführt ist, um eine Reset-Zone, die in dem Substrat (1) vorgesehen ist, mit der Photovoltaik-Umwandlungszone (2) zu verbinden.

10. Struktur nach dem vorstehenden Anspruch, wobei die Reset-Zone durch ein Kontakt-Substrat (7), das aus einer stark dotierten Zone des ersten Typs in dem Substrat (1) konstituiert ist, gebildet wird.

11. Struktur nach Anspruch 9, wobei die Reset-Zone aus einer stark dotierten Zone konstituiert ist, die durch eine variable Spannung Vx polarisiert ist, um die variable Spannung Vx bis zum schwebenden Diffusionsknoten (FD) auszubreiten, der der Lastansammlungszone (3) zugeordnet ist.

12. Struktur nach einem der vorstehenden Ansprüche, umfassend einen schwebenden Diffusionsknoten (FD), der der Lastansammlungszone (3) zugeordnet ist, wobei die gemeinsame Leseschaltung (13) umfasst:
- eine Lastübertragungsstruktur (13a), ausgeführt zum Lesen der Spannung eines schwebenden Diffusionsknotens, der der zweiten Photodiode zugeordnet ist,
- eine Spannungsverschiebungsschaltung (13b), die die erste Photodiode über einen Reset-Transistor (Ts1) der Lastübertragungsstruktur mit dem schwebenden Diffusionsknoten (FD) verbindet.

13. Struktur nach dem vorstehenden Anspruch, wobei die Spannungsverschiebungsschaltung (13b) einen Transistor mit negativer Schwellenspannung (Ts1) beinhaltet, dessen Gate mit der Photovoltaik-Umwandlungszone (2) verknüpft ist.

14. Struktur nach Anspruch 11, einen schwebenden Diffusionsknoten (FD) umfassend, der der Lastansammlungszone (3) zugeordnet ist, wobei die gemeinsame Leseschaltung (13) eine Lastübertragungsstruktur (13a) umfasst, die ausgeführt ist, um die Spannung eines schwebenden Diffusionsknotens zu lesen, der der zweiten Photodiode zugeordnet ist, und wobei die Photovoltaik-Umwandlungszone (2) durch einen Kondensator (CX) mit dem schwebenden Diffusionsknoten verbunden ist.

15. Sensor, umfassend
- eine Vielzahl einer Pixelstruktur nach einem der Ansprüche 1 bis 14,
- mindestens eine Ausgangsschaltung, die die Lesung der Spannung der ersten Photodiode und die Lesung einer Messung der Lasten der zweiten Photodiode kombiniert.

16. Funktionsverfahren eines aktiven CMOS-Pixels, der eine Struktur nach einem der Ansprüche 1 bis 14 präsentiert, wobei
- die erste Photodiode im Photovoltaik-Modus wirkt und photoelektrische Lastenträger, die durch den PN-Anschluss beim Aussetzen der ersten Photodiode einer Strahlung erfasst werden, neu sendet,
- die zweite Photodiode in Sperrrichtung polarisiert ist und im Integrationsmodus wirkt, wobei die Lastansammlungszone den Lastenträgern ausgesetzt ist, die aus der Photovoltaik-Umwandlungszone stammen, um solche Lastenträger anzusammeln,
- die Spannung der ersten Photodiode und eine Messung der Lasten der zweiten Photodiode von einer gemeinsamen Leseschaltung (13) der ersten und zweiten Photodiode im Bereich des Pixels gelesen werden, die mit einem gemeinsamen COL Bus verbunden ist, um die Spannung der ersten Photodiode zu lesen und eine Messung der Lasten der zweiten Photodiode zu lesen.

## Claims

1. Active pixel structure of CMOS type, comprising:
- a semiconductor substrate (1) of a first type,
- at least one first photodiode configured to operate in photovoltaic mode during exposure of said first photodiode to radiation, comprising a photovoltaic conversion region (2) defined by a doped region of a second type forming a PN junction with the substrate, said first photodiode being configured to re-emit photoelectric charge carriers captured by the PN junction during exposure of said first photodiode to radiation;
- at least one second photodiode configured to operate in integration mode and to be reverse biased during exposure of said first photodiode to radiation, said second photodiode comprising a charge accumulation region (3) defined by a doped region of the second type forming a PN junction with the substrate, said charge accumulation region being configured to be exposed to the charge carriers originating from the photovoltaic conversion region (2) so as to accumulate said charge carriers; and
- readout means to read the voltage of the first photodiode and to read charge measurement at the second photodiode comprising a readout circuit (13) common to the first photodiode and second photodiode, at the pixel, connected to a common bus COL to read the voltage of the first photodiode and to read charge measurement at the second photodiode.

2. Structure according to the preceding claim, wherein the photovoltaic conversion region (2) and the charge accumulation region (3) are separated by a portion of substrate through which the charge carriers re-emitted by the first photodiode pass for collection and accumulation in the accumulation region, so that the depletion region of the PN junction of the first photodiode and the depletion region of the PN junction of the second photodiode are separate and do not touch one another.

3. Structure according to one of the preceding claims, wherein the substrate (1) has spatially modulated doping (8) defining a containment region for the charge carriers, said containment region grouping together the first and second photodiode.

4. Structure according to one of claims 2 to 3, wherein the distance between the photovoltaic conversion region (2) and the charge accumulation region (3) is between 0.1 µm and 100 µm.

5. Structure according to one of the preceding claims, wherein the first photodiode(s) and the second photodiode(s) are intercalated in the substrate so that a photovoltaic conversion region (2) lies adjacent to at least one charge accumulation region (3).

6. Structure according to one of the preceding claims, wherein the photovoltaic conversion region (2) and the charge accumulation region (3) are at least partly overlaid.

7. Structure according to the preceding claim, wherein the charge accumulation region (3) has a spatial extension covering at least the extent of said photovoltaic conversion region (2).

8. Structure according to one of the preceding claims, wherein the second photodiode comprises a passivation layer having doping of the same type as the substrate and separating the charge accumulation region (3) from a surface of the substrate.

9. Structure according to one of the preceding claims, wherein a reset transistor (RSTLOG) is adapted to connect a reset region arranged in the substrate (1) to the photovoltaic conversion region (2).

10. Structure according to the preceding claim, wherein the reset region is formed by a substrate-contact (7) formed by a heavily doped region of the first type in the substrate (1).

11. Structure according to claim 9, wherein the reset region is formed by a heavily doped region biased with a variable voltage Vx, to propagate said variable voltage Vx as far as the floating diffusion node (FD) associated with the charge accumulation region (3).

12. Structure according to one of the preceding claims, comprising a floating diffusion node (FD) associated with the charge accumulation region (3), wherein the common readout circuit (13) comprises:
- a charge transfer structure (13a) adapted to read the voltage of a floating diffusion node associated with the second photodiode;
- a voltage offset circuit (13b) connecting the first photodiode to the floating diffusion node (FD) via a reset transistor (Ts1) of the charge transfer structure.

13. Structure according to the preceding claim, wherein the voltage offset circuit (13b) comprises a negative threshold voltage transistor (Ts1) the gate of which is connected to the photovoltaic conversion region (2).

14. Structure according to claim 11, comprising a floating diffusion node (FD) associated with the charge accumulation region (3), wherein the common readout circuit (13) comprises a charge transfer structure (13a) adapted to read the voltage of a floating diffusion node associated with the second photodiode,
and wherein the photovoltaic conversion region (2) is connected to the floating diffusion node via a capacitor (CX).

15. Sensor comprising:
- a plurality of pixel structures according to one of claims 1 to 14;
- at least one output circuit combining the readout of the voltage of the first photodiode with the readout of charge measurement at the second photodiode.

16. Operating process of an active pixel of CMOS type having a structure according to any one of claims 1 to 14 wherein:
- the first photodiode operates in photovoltaic mode and re-emits photoelectric charge carriers captured by the PN junction during exposure of said first photodiode to radiation;
- the second photodiode is reverse biased and operates in integration mode, said charge accumulation region being exposed to the charge carriers originating from the photovoltaic conversion region so as to accumulate said charge carriers;
- the voltage of the first photodiode and charge measurement at the second photodiode are read by a readout circuit (13) common to the first photodiode and second photodiode, at the pixel, connected to a common bus COL to read the voltage of the first photodiode and to read charge measurement at the second photodiode.
